(19) Europäisches Patentamt
European Patent Office
Office européen des brevets

(11) Veröffentlichungsnummer : **0 023 988**
**B1**

(12) # EUROPÄISCHE PATENTSCHRIFT

(45) Veröffentlichungstag der Patentschrift : **29.02.84**

(51) Int. Cl.$^3$ : **G 03 C 1/72**, G 03 C 1/68

(21) Anmeldenummer : **80104214.4**

(22) Anmeldetag : **18.07.80**

(54) **Verwendung eines leitenden organischen Ladungsübertragungsmaterials als elektronenstrahlempfindliches Resistmaterial und Verfahren zur Herstellung positiver und negativer Resistbilder.**

(30) Priorität : **09.08.79 US 65291**

(43) Veröffentlichungstag der Anmeldung : **18.02.81 Patentblatt 81/07**

(45) Bekanntmachung des Hinweises auf die Patenterteilung : **29.02.84 Patentblatt 84/09**

(84) Benannte Vertragsstaaten : **DE FR GB**

(56) Entgegenhaltungen :
**EP-A- 0 020 896**
**US-A- 3 925 076**
**IBM TECHNICAL DISCLOSURE BULLETIN, Band 13, Nr. 1, Juni 1970, Seite 6 New York, U.S.A. J.A. PIROG: "Electroconductive electron beam resist"**

(73) Patentinhaber : **International Business Machines Corporation**
**Old Orchard Road**
**Armonk, N.Y. 10504 (US)**

(72) Erfinder : **Engler, Edward Martin**
**21 Orchard Drive**
**Wappingers Falls, New York 12590 (US)**
Erfinder : **Kuptsis, John Demosthenes**
**77-D Independence Ct.**
**Yorktown Heights, New York 10598 (US)**
Erfinder : **Schad, Robert Gerard**
**164 Phyllis Ct.**
**Yorktown Heights, New York 10598 (US)**
Erfinder : **Tomkiewicz, Yaffa**
**Lalli Drive, RFD 4**
**Katonah, New York 10536 (US)**

(74) Vertreter : **Kreidler, Eva-Maria, Dr. rer. nat.**
**Schönaicher Strasse 220**
**D-7030 Böblingen (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Jouve, 18, rue St-Denis, 75001 Paris, France

# Verwendung eines leitenden organischen Ladungsübertragungsmaterials als elektronenstrahlempfindliches Resistmaterial und Verfahren zur Herstellung positiver und negativer Resistbilder

Die Erfindung betrifft die Verwendung eines leitenden organischen Ladungsübertragungsmaterials als elektronenstrahlempfindliches Resistmaterial und ein Verfahren zur Herstellung positiver und negativer Resistbilder.

In der Literatur sind zahlreiche strahlungsempfindliche Resistmaterialien und deren Verwendung zur Herstellung von Mustern bei der Herstellung elektronischer Schaltkreise beschrieben. Eine Musterbildung in diesen Materialien hängt von den Löslichkeitsunterschieden zwischen bestrahlten und nichtbestrahlten Bereichen ab. Die Löslichkeitsunterschiede werden entweder durch Aufbrechen von Bindungen (Kettenabbrüche) oder Ausbildung von Bindungen (Vernetzungen) in polymeren Systemen bewirkt. Dies geschieht durch Einwirkung aktinischer Strahlung, Elektronen- oder Röntgenstrahlung.

Die bisher bekannten Materialien weisen mehrere Nachteile auf, unter anderem besteht die Schwierigkeit, scharfe Bilder mit hoher Auflösung zu erhalten, insbesondere bei Anwendung negativer Resistmaterialien. Dies ist zurückzuführen auf das Aufquellen der Polymermaterialien während der Entwicklung mit Lösungsmitteln. Die Filme aus bisher bekannten Materialien sind im allgemeinen isolierend und neigen daher zum Aufbau statischer Ladung auf ihren Oberflächen während der Bestrahlung. Bisher wurde dieses Problem gelöst, indem man einen dünnen metallischen Film auf dem Polymerresistmaterial abschied. Weiterhin ist es schwierig, mit der Lösungsmittel-Beschichtungstechnologie Filme einheitlicher Schichtdicke auf Oferflächen mit einer Topographie abzuscheiden.

Der Stand der Technik in der Elektronenstrahllithographie kann nachgelesen werden in einer Übersicht mit dem Titel « CRC Criticals Review » von M. J. Bowden, Solid State and Material Sciences, *8*, 223 (1979).

Aus dem IBM Technical Disclosure Bulletin, Vol. 13, Nr. 1, Juni 1970, Seite 6 ist ein Elektronenstrahlresist aus einem Ladungsübertragungskomplexbildner und Polymeren oder Copolymeren vom Vinyltyp bekannt.

In Chemical Abstracts Vol. 83, 1975, Seite 453, Nr. 177569g ; Vol. 86, 1977, Seite 684, Nr. 86 : 99510b und Vol. 87, 1977, Seite 429, Nr. 87 : 38338a sind Tetrathiofulvalenbromide, Jodide und Rhodanide und deren Eigenschaften beschrieben. Im Chemical Abstracts, Vol. 90, 1979, Seite 540, Nr. 90 : 47009h und Seite 542, Nr. 90 : 151387r sind Bis(tetrathiotetracen)trijodide und deren Eigenschaften beschrieben.

Aufgabe der Erfindung ist eine neue Verwendung für Ladungsübertragungsmaterialien aus Chloriden, Bromiden und Jodiden der Tetraheterofulvalene, der Tetraheterotetracene, der Tetraheteronaphthaline, des Perylens, der Diheterodipyrane, des Tetramethylphenylendiamins, der Phthalocyanine und Porphyrine anzugeben.

Gemäß Anspruch 1 werden die zuvor genannten Verbindungen als elektronenstrahlempfindliches Resistmaterial verwendet.

Die Erfindung umfaßt auch Verfahren zur Herstellung positiver und negativer Resistbilder. Die Resistmaterialien weisen eine Reihe von Vorteilen auf, u. a. große Löslichkeitsunterschiede und optische und elektrische Eigenschaften, die aus der Bestrahlung resultieren. Diese Eigenschaften machen sie zur Verwendung bei der Herstellung von Mikrostrukturen für elektronische Schaltkreise hoher Integrationsdichte, als optische Speichermedien, zur Herstellung von Maskenvorlagen zur Verwendung in der Photolithographie geeignet und gestatten die Eliminierung statischer Aufladungen in dem Resistmaterial während der Bestrahlung mit Elektronen oder Ionen. Die Elektronenstrahl-Resistmaterialien können in Abhängigkeit von den Strahlungsenergieparametern zur Herstellung entweder eines positiven oder eines negativen Resistbildes verwendet werden.

Das wesentliche ist, daß die Materialien aus verschiedenen Klassen leitender, organischer π-Donor-Komplexe gewählt werden können. Beispielsweise kann der π-Donor-Bestandteil gewählt werden aus der Gruppe der Tetraheterofulvalene und deren Derivaten mit der allgemeinen Formel

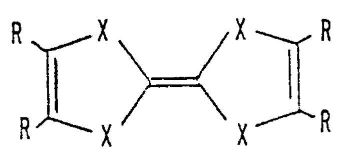

in der X S und/oder Se und R = H, Alkyl wie $CH_3$, $C_2H_5$ oder beide benachbarte Reste R Hexamethylen bedeuten ;

aus der Gruppe der Tetraheterotetracene und deren Derivate mit der allgemeinen Formel

(Siehe Figur Seite 3 f.)

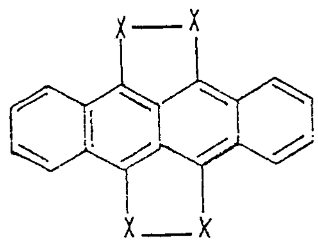

in der X S und/oder Se ist ;

aus der Gruppe der Tetraheteronaphthaline und deren Derivate mit der allgemeinen Formel

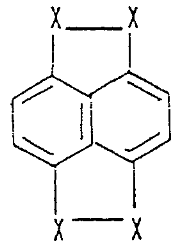

in der X S und/oder Se ist ;

aus der Gruppe der Perylene und deren Derivate mit der allgemeinen Formel

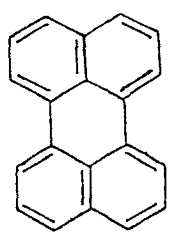

aus der Gruppe der Diheterodipyrane und deren Derivate mit der allgemeinen Formel

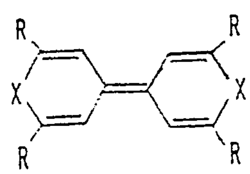

in der X S und/oder Se oder N-Alkyl und R = Alkyl oder Phenyl bedeuten ;

aus der Gruppe der Tetramethylphenylendiamine und deren Derivate mit der allgemeinen Formel

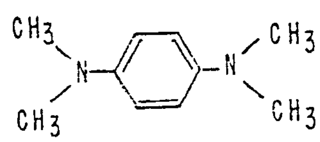

aus der Gruppe der Phthalocyanine und deren Derivate mit der allgemeinen Strukturformel

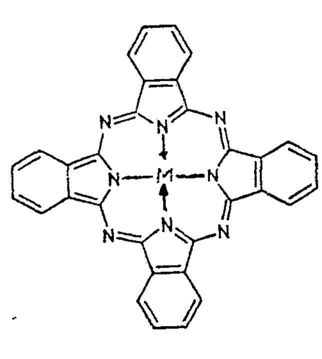

in der M ein Übergangsmetall, beispielsweise Nickel, Kupfer, Eisen, Kobalt oder Platin ist ; und

aus der Gruppe der Porphyrine und deren Derivate mit der allgemeinen Strukturformel

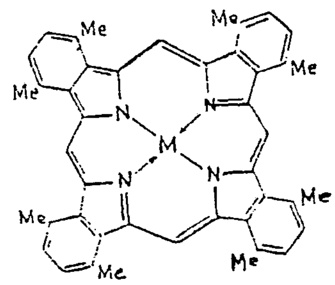

in der M ein Übergangsmetall und Me = methyl ist.

Der zuvor angegebene π-Donor-Bestandteil bildet in Gegenwart von Halogen leitende Ladungsübertragungszusammensetzungen nach der nachfolgenden Reaktionsgleichung :

$$\pi\text{-Donor} + X_2 \rightarrow (\pi\text{-Donor})_{1-n}\ (\pi\text{-Donor}^+)_n\ (X^-)_n$$

$$o < n < 1$$

X kann Chlor, Brom oder Jod sein.

Es ist allgemein bekannt, daß zum Erhalt hoher Leitfähigkeit das stöchiometrische Verhältnis (d. h. n in der obigen Gleichung) des Ladungsübertragungssalzes kleiner als 1 sein muß. Der Wert von n kann im allgemeinen in einem Bereich zwischen 0 und 1 variieren, ohne daß die leitenden Eigenschaften wesentlich beeinflußt werden.

Es wurde gefunden, daß die zuvor angegebenen Ladungsübertragungssalze die Basis eines neuen lithographischen Verfahrens bilden. Dieses Verfahren basiert auf der Feststellung, daß bei Bestrahlung des Ladungsübertragungssalzes mit einem Elektronenstrahl entsprechender Energiedichte ein Verlust des Halogens in dem Ladungsübertragungssalz in den bestrahlten Bereichen stattfindet ; d. h., der Elektronenstrahl bewirkt die Umkehr einer Ladungsübertragungsreaktion gemäß der nachfolgenden Gleichung :

$$\pi(\text{Donor})_{1-n}\ (\pi\text{-Donor}^+)_n\ (X^-)_n \xrightarrow{\text{Elektronenstrahleinwirkung}} \pi\text{-Donor} + X_2\uparrow.$$

Im allgemeinen können diese Ladungsübertragungssalze durch Sublimation abgeschieden werden. Dabei werden glatte, festhaftende und glasartige Filme erhalten. Filme mit einer einheitlichen Schichtdicke im Bereich von 300 nm bis 2 µm oder darüber konnten auf diese Art und Weise abgeschieden werden. In den Fällen, in denen das Salz einen niedrigen Dampfdruck hat oder thermisch instabil ist, können die Filme durch Lösungsbeschichtungstechnologie hergestellt werden.

Es wurde weiterhin festgestellt, daß mit diesen Materialien sowohl negative wie auch positive Resistbilder hergestellt werden können. Der Bildmodus hängt von den Parametern des Elektronenstrahls ab, d. h. von seiner Energie und Ladungsdichte. Beispielsweise liegt für negative Bilder die Elektronenstrahlenergie in einem Bereich von $8{,}01 \cdot 10^{-19}$ bis $48{,}06 \cdot 10^{-19}$ Joule. Die Ladungsdichte liegt in einem Bereich von unter $10^{-3}$ bis $10^{-4}$ C/cm². Die Bestrahlung erfolgt bei Zimmertemperatur. Die Bilder werden in geeigneten polaren Lösungsmitteln wie kurzkettigen Alkoholen, Wasser, Dimethylformamid, Dimethylsulfoxid, Acetonitril und dergleichen entwickelt.

In dem negativen Bild findet eine Vernetzungsreaktion statt unter Erhalt der gewünschten Muster, die in heißen Lösungsmitteln nicht mehr verändert werden. Beispielsweise wurde ein negatives Bild, das in einem Film aus Tetrathiofulvalenbromid hergestellt wurde, durch Behandlung in kochendem Chlorbenzol, Dimethylsulfoxid und dergleichen nicht mehr verändert. Das Bild wurde auch Temperaturen von 275 °C im Vakuum bei $1{,}33 \times 10^{-9}$ bar unterworfen, wobei ebenfalls keine Veränderung eintrat. Die Bilder lassen sich leicht durch eine 1 bis 2 Minuten dauernde Behandlung mit wässrigem Hydrazin bei Zimmertemperatur entfernen. Die negativen Resistbilder haben Dimensionen von weniger als 1 µm, weisen eine ausgezeichnete Kantendefinition von 0,1 µm auf, und es können nahezu vertikale Seitenwände erhalten werden. Es fand kein Aufquellen der Bilder statt, wenn diese mit einer Vielzahl polarer und nichtpolarer Lösungsmittel behandelt wurden.

Positive Resistbilder können entweder *in situ* oder durch Lösungsmittelentwicklung hergestellt werden. Bei dem *in situ*-Verfahren wird der Resist mit einem Elektronenstrahl mit einer Ladungsdichte im Bereich von über $10^{-3}$ bis $10^{-1}$ C/cm² und einer Energie von $8{,}01 \cdot 10^{-19}$ bis $48{,}06 \cdot 10^{-19}$ Joule bestrahlt. Bei diesen Ladungsdichteniveaus verdampfen die bestrahlten Resistmaterialien. Diese Sublimation kann noch durch Erhitzen der Unterlagen, auf denen sich der Resist befindet, auf Temperaturen im Bereich von 60 bis 100 °C verstärkt werden.

Mit Lösungsmittel entwickelte, positive Bilder werden in denjenigen Fällen erhalten, in denen die Ladungsübertragungssalze nicht ohne weiteres verdampfen bei der Bestrahlung und nach dem Halogenverlust. Daß bei der Bestrahlung ein Halogenverlust stattfindet, wird mit der Elektronenmikrosonden-Technologie festgestellt. Die bestrahlten Materialien sind leicht mit schwach polaren Lösungsmitteln wie Methylenchlorid, Chloroform, Kohlenstofftetrachlorid und dgl. entfernbar. Der Vorteil der Lösungsmittelentwicklung liegt darin, daß im Prinzip empfindlichere, positive Resistmaterialien angewendet werden können. Ein weiteres Merkmal der Lösungsmittelentwicklung ist, daß weniger flüchtige Donoren im Bildbeschichtungsprozeß eingesetzt werden können.

Es konnte auch festgestellt werden, daß die bestrahlten und nicht bestrahlten Materialien gemäß der Erfindung verschiedene elektrische und optische Eigenschaften aufweisen. Es war bekannt, daß die nicht bestrahlten Filme hochleitend waren mit Leitfähigkeiten im Bereich von 0,1 bis 20/Ohm-cm. Diese Leitfähigkeit ist von praktischem Vorteil, weil durch sie der Aufbau statischer Ladungen in dem Film während der Bestrahlung vermieden wird. Bei bisher bekannten isolierenden Polymerresistmaterialien mußte deswegen ein dünner metallischer Überzug auf dem Resist abgeschieden werden. Mit den vorliegenden Materialien ist dies nicht mehr erforderlich. Während der nichtbestrahlte Bereich hohe Leitfähigkeit aufweist, wurde gefunden, daß der bestrahlte resist isolierend ist. Es wurde beispielsweise gefunden, daß ein Film aus Tetrathiofulvalenbromid ; der auf eine Unterlage durch Sublimation aufgetragen wurde und dessen Leitfähigkeit gemessen und mit der eines entwickelten negativen Elektronenstrahlbildes verglichen wurde, eine Änderung der Leitfähigkeit um 8 Größenordnungen oder darüber aufwies. Der nichtbestrahlte Resist zeigte eine Leitfähigkeit von 20/Ohm-cm, während die bestrahlten Bereiche eine Leitfähigkeit von weniger als $10^{-7}$/Ohm-cm aufwiesen.

Es wurde auch beobachtet, daß große Änderungen der optischen Eigenschaften in den bestrahlten Bereichen des Resists auftraten. Es wurde beobachtet, daß die nichtbestrahlten Resistfilme stark im sichtbaren und im nahen Infrarotbereich Licht absorbieren, während die bestrahlten Filme in diesen Bereichen keine Absorptionen aufwiesen. Beispielsweise wurde gefunden, daß Tetrathiofulvalenbromidfilme starke Absorptionen bei 550 und bei 380 nm aufwiesen. Nach der Bestrahlung ergaben optische Messungen, daß diese Absorptionen in den bestrahlten Bereichen nicht mehr vorhanden waren. Es sollte hevorgehoben werden, daß eine Entwicklung nicht erforderlich ist, um optisch die mit Elektronenstrahl eingeschriebenen Muster in den vorliegenden Filmen feststellen zu können. Die optische Absorption hängt natürlich auch von der Zusammensetzung ab. Beispielsweise absorbieren Ladungsübertragungssalze von Tetrathiotetracen und Tetraphenyldithiodipyran stark im Bereich von 800 bis 850 nm. Der Unterschied in der Lichtabsorption nichtbestrahlter Materialien gegenüber bestrahlten Materialien gestattet die Anwendung der Materialien als optische Masken und in Video-Speichervorrichtungen.

Die Empfindlichkeit des lithographischen Verfahrens und die optischen und elektrischen Eigenschaften der erfindungsgemäßen Resistmaterialien sind von dem entsprechenden Halogengehalt und den Parametern des Elektronenstrahls abhängig.

Es wurde gefunden, daß eine Empfindlichkeitssteigerung bei der Umkehr der Ladungsübertragungsreaktion stattfindet, wenn man vom Tetrathiofulvalenbromid zu dem entsprechenden Chlord übergeht. Durch diesen Übergang findet eine Empfindlichkeitssteigerung um einen Faktor größer 5 statt. In einem anderen Beispiel wird ein Film aus einem neutralen Donor abgeschieden und dann mit Halogen behandelt unter Erhalt eines Ladungsübertragungssalzes mit einem kleineren molaren Gehalt an Halogen. Bei Elektronenbestrahlung dieses Materials ist daher weniger,Halogen zu entfernen, was zu einer entsprechenden Steigerung der Empfindlichkeit führt.

Die Erfindung wird anhand der nachfolgenden Ausführungsbeispiele näher erläutert.

Beispiel 1

Es wird ein Film aus Tetrathiofulvalenbromid ($TTF\text{-}Br_n$) mit einer Schichtdicke von 500 nm durch Vakuumsublimation von $TTF\text{-}Br_n$ bei einem Druck von 1 µm und bei einer Temperatur von 185 bis 190 °C hergestellt. Die Sublimation wird für 10 Minuten aufrecht erhalten. Die Analyse des so hergestellten Films zeigte eine nichtstöchiometrische Zusammensetzung von $TTF\text{-}Br_{0,78}$.

Es wird ein Bild in diesem Film hergestellt, indem man einen Elektronenstrahl in einem vorbestimmten Muster auftreffen läßt. Der Elektronenstrahl hatte eine Stromdichte von $10^{-4}$ C/cm$^2$ und eine Energie von 10 keV. Der Film wird dann 15 Sekunden lang bei Zimmertemperatur mit Methanol gewaschen, um die nichtbelichteten Bereiche des Films zu entfernen. Es blieb ein negatives Resistbild mit Dimensionen kleiner 1 µm zurück. Dieses Bild bleibt unverändert, wenn es kochendem Chlorbezol oder Dimethylsulfoxid ausgesetzt wurde oder im Vakuum auf 275 °C erhitzt wurde. Es wird jedoch entfernt, wenn es mit wässriger Hydrazinlösung 1 bis 2 Minuten lang bei Zimmertemperatur behandelt wird.

An dem Film wurden vor und nach der Bestrahlung optische und Leitfähigkeitsmessungen durchgeführt. Vor der Bestrahlung wies der Film die charakteristischen TTF-Br-Salz Absorptionen bei 550 und 380 nm auf. Nach der Bestrahlung fehlten diese Absorptionen. In ähnlicher Weise betrug die Leitfähigkeit des Films 20/Ohm-cm vor der Bestrahlung und danach kleiner $10^{-7}$/Ohm-cm.

Beispiel 2

Ein Film von $TTF\text{-}Br_{0,78}$ wird wie in Beispiel 1 angegeben hergestellt. Der Film wird in einem vorbestimmten Muster mit einem Elektonenstrahl mit einer Stromdichte von $10^{-3}$ C/cm$^2$ und einer Energie von 10 KeV bestrahlt. Nach der Bestrahlung wurde gefunden, daß der beaufschlagte Film entfernt war unter Erhalt eines positiven Resistbildes. Das Bild zeigte Dimensionen kleiner 1 µm mit

nahezu vertikalen Seitenwänden. Eine weitere Entwicklung ist nicht erforderlich.

Beispiel 3

Ein Film aus Tetrathiofulvalenchlorid (TTF-$Cl_{0.65}$) wird wie in Beispiel 1 angegeben hergestellt, mit der Ausnahme, daß eine Badtemperatur von 195 bis 205 °C angewendet wird. Die Stöchiometrie des Films betrug TTF-$Cl_{0.65}$. Der Film wird bestrahlt und anschließend, wie in Beispiel 1 angegeben, zu einem negativen Bild entwickelt. Es wurde gefunden, daß die Löslichkeit, die optischen und elektrischen Eigenschaften dem Film, der in Beispiel 1 abgeschieden wurde, ähneln. Es wurde weiterhin gefunden, daß der TTF-$Cl_{0.65}$-Film etwa 5 mal empfindlicher als der TTF-$BR_{0.78}$-Film von Beispiel 1 ist.

Beispiel 4

Ein Film aus TTF-$Cl_{0.65}$ wird, wie in Beispiel 3 angegeben, hergestellt und wie in Beispiel 2 angegeben bestrahlt und behandelt. Es wird ohne Lösungsmittelentwicklung ein positives Resistbild erhalten. Das Bild weist Dimensionen kleiner 1 µm mit nahezu vertikalen Wänden auf.

Beispiel 5

Ein Film aus Tetrathiofulvalenjodid (TTF-$J_n$) wird hergestellt nach dem Verfahren von Beispiel 1 mit der Ausnahme, daß auf eine Temperatur von 140 bis 150 °C erhitzt wird. Die Analyse des Films ergab eine Stöchiometrie von TTF-$J_{0.7}$. Der Film wird bestrahlt und anschließend behandelt wie analoge Filme in den Beispielen 1 und 2 unter Erhalt negativer und positiver Resistbilder. Die Löslichkeit, die optischen und elektrischen Eigenschaften ähneln denen der Filme gemäß den Beispielen 1 und 2.

Beispiel 6

Ein Film aus Tetraselenofulvalenbromid (TSeF-$Br_n$) wird wie in Beispiel 1 angegeben, hergestellt, und es wird eine Filmzusammensetzung von TSeF-$Br_{0.8}$ erhalten. Dieser Film wird bestrahlt und anschließend behandelt wie in den Beispielen 1 und 2 unter Erhalt der entsprechenden negativen und positiven Resistbilder. Optische Messungen ergaben, daß der nichtbestrahlte Film starke Absorptionen bei 430 und 650 nm aufwies. Ähnliche Änderungen in der Löslichkeit, den optischen und elektrischen Eigenschaften wie in Beispiel 1 wurden beobachtet.

Beispiel 7

Tetrathiotetracen (TTT) wird im Vakuum bei 1 µm und 350 °C sublimiert unter Erhalt eines neutralen TTT-Films. Der Film wird dann etwa 10 Minuten lang einem Bromdampf ausgesetzt, wodurch ein leitender Film mit der Stöchiometrie TTT-$Br_{0.1}$ erhalten wird. Dieser Film wird bestrahlt und behandelt wie in den Beispielen 1 und 2, wodurch negative und positive Resistbilder mit ähnlichen Änderungen der elektrischen Eigenschaften wie in den vorherigen Beispielen erhalten werden.

Es können auch Halogensalze der nachfolgenden Materialien in ähnlicher Weise als Elektronenstrahl-Resistmaterialien eingesetzt und behandelt werden wie in den zuvor beschriebenen Beispielen :

Diselenodithiofulvalen,
Dimethyltetrathiofulvalen,
Dimethyltetraselenofulvalen,
Dimethyldiselenodithiofulvalen,
Tetramethyltetrathiofulvalen,
Tetramethyltetraselenofulvalen,
Tetramethyldiselenodithiofulvalen,
Hexamethylentetrathiofulvalen,
Hexamethylentetraselenofulvalen,
Hexamethylendiselenodithiofulvalen,
Tetrathionaphthalin,
Tetraselenonaphthalin,
Perylen,
Dithiodipyran,
Tetramethyldithiodipyran,
Tetraphenyldithiodipyran,
Diselenodipyran,
Tetramethyldiselenodipyran,
Tetraphenyldiselenodipyran,
Dipyran,

Tetramethylphenylendiamin,
Phthalocyanin,
Nickel-, Kupfer-, Kobalt-, Eisen-phthalocyanin,
Octamethyltetrabenzporphyrin,
Nickel-octamethyltetrabenzporphyrin.

In der vorliegenden Erfindung wird die Verwendung einer Klasse von Resistmaterialien beschrieben, die allgemein als leitende organische Ladungsübertragungssalze klassifiziert werden können. Mit diesen Materialien können sowohl negative wie auch positive Resistbilder nur durch Kontrolle der Bestrahlungsparameter, d. h. der Energie und der Stromdichte hergestellt werden. Die Resistmaterialien weisen weiter Vorteile auf, beispielsweise große Unterschiede in der Löslichkeit, in den optischen und elektrischen Eigenschaften, die aus der Bestrahlung resultieren. Diese Eigenschaften machen die Materialien für die Herstellung von Mikrostrukturen für elektronische Schaltkreise mit hoher Integrationsdichte, für die Verwendung als optische Speichermedien und zur Herstellung von Maskenvorlagen für die Photolithographie geeignet. Außerdem findet eine Eliminierung statischer Ladungen in dem Resist während der Elektronen- oder Ionenbestrahlung statt.

**Ansprüche**

1. Verwendung eines leitenden organischen Ladungsübertragungsmaterials aus der Gruppe von Chloriden, Bromiden und Jodiden der Tetraheterofulvalene der allgemeinen Formel

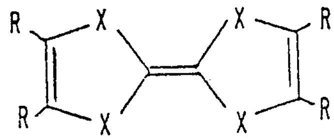

in der X S und/oder Se und R = H, Alkyl oder beide benachbarte Reste R Hexamethylen bedeuten ;
der Tetraheterotetracene der allgemeinen Formel

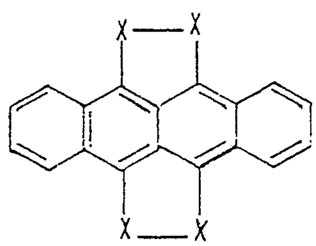

in der X S und/oder Se ist ;
der Tetraheteronaphthaline der allgemeinen Formel

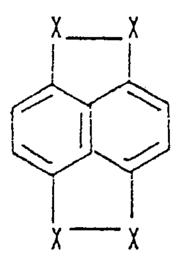

in der X S und/oder Se ist ;
des Perylens ;
der Diheterodipyrane der allgemeinen Formel

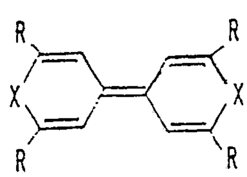

in der X S und/oder Se oder N-Alkyl und R = Alkyl oder Phenyl bedeuten ;
des Tetramethylphenylendiamins ;
der Phthalocyanine und Porphyrine ;
in denen das stöchiometrische Verhältnis des Ladungsübertragungssalzes kleiner 1 ist, als elektronenstrahlempfindliches Resistmaterial.

2. Verwendung von Chloriden, Bromiden und Jodiden von Tetrathiofulvalen, Tetraselenofulvalen und Diselenodithiofulvalen gemäß Anspruch 1.

3. Verwendung von Chloriden, Bromiden und Jodiden von Dimethyltetrahiofulvalen, Dimethyltetraselenofulvalen und Dimethyldiselenodithiofulvalen gemäß Anspruch 1.

4. Verwendung von Chloriden, Bromiden und Jodiden von Tetramethyltetrathiofulvalen, Tetramethyltetraselenofulvalen und Tetramethyldiselenodithiofulvalen gemäß Anspruch 1.

5. Verwendung von Chloriden, Bromiden und Jodiden von Hexamethylentetrathiofulvalen, Hexamethylentetraselenofulvalen und Hexamethylendiselenodithiofulvalen gemäß Anspruch 1.

6. Verwendung von Chloriden, Bromiden und Jodiden von Tetrathiotetracen gemäß Anspruch 1.

7. Verwendung von Chloriden, Bromiden und Jodiden von Tetrathionaphthalin und Tetraselenonaphthalin gemäß Anspruch 1.

8. Verwendung von Chloriden, Bromiden und Jodiden von Dipyran, Dithiodipyran und Dieselenodipyran gemäß Anspruch 1.

9. Verwendung von Chloriden, Bromiden und Jodiden von Tetramethyldithiodipyran, Tetraphenyldithiodipyran, Tetramethyldiselenodipyran und Tetraphenyldiselenodipyran gemäß Anspruch 1.

10. Verwendung von Chloriden, Bromiden und Jodiden von Phthalocyanin, Nickel- Kupfer-, Kobalt- und Eisenphthalocyanin gemäß Anspruch 1.

11. Verwendung von Chloriden, Bromiden und Jodiden von Octamethyltetrabenzporphyrin gemäß Anspruch 1.

12. Verfahren zur Herstellung eines positiven Resistbildes, bei dem ein Film aus einem leitenden organischen Ladungsübertragungsmaterial auf eine Unterlage aufgetragen und mit einem Elektronenstrahl in einem vorbestimmten Muster bestrahlt wird, der eine ausreichende Energie und Stromdichte aufweist, um den Film in den bestrahlten Bereichen unter Ausbildung eines positiven Bildes zu verdampfen, dadurch gekennzeichnet, daß ein Resistmaterial gemäß einem der Ansprüche 1 bis 11 verwendet wird.

13. Verfahren nach Anspruch 12, dadurch gekennzeichnet, daß ein Elektronenstrahl mit einer Energie von $8{,}01 \cdot 10^{-19}$ bis $48{,}06 \cdot 10^{-19}$ J und einer Ladungsdichte von über $10^{-3}$ bis $10^{-1}$ C/cm$^2$ angewendet wird.

14. Verfahren zur Herstellung eines negativen Resistbildes, bei dem ein Film aus einem leitenden organischen Ladungsübertragungsmaterial auf eine Unterlage aufgetragen und mit einem Elektronenstrahl in einem vorbestimmten Muster bestrahlt wird, der eine ausreichende Energie und Stromdichte aufweist, um den Film in den bestrahlten Bereichen zu vernetzen und die nichtbelichteten Bereiche des Films mit einem Lösungsmittel unter Ausbildung eines negativen Bildes entfernt werden, dadurch gekennzeichnet, daß ein Resistmaterial gemäß einem der Ansprüche 1 bis 11 verwendet wird.

15. Verfahren nach Anspruch 14, dadurch gekennzeichnet, daß ein Elektronenstrahl mit einer Energie von $8{,}01 \cdot 10^{-19}$ bis $48{,}06 \cdot 10^{-19}$ J und einer Ladungsdichte von unter $10^{-3}$ bis $10^{-4}$ C/cm$^2$ angewendet wird.

## Claims

1. Use of a conducting organic charge transfer material selected from the group consisting of chlorines, bromines, and iodines of the tetraheterofulvalenes of the general formula

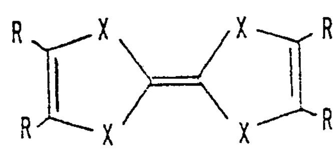

where X is S and/or Se and R = H, alkyl or both adjacent residues represent R hexamethylene ;
of the tetraheterotracenes of the general formula

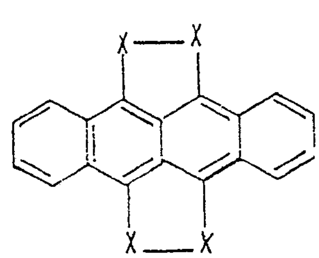

where X is S and/or Se ;

of the tetraheteronaphtalenes of the general formula

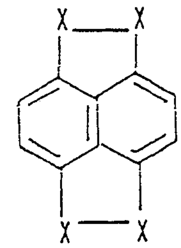

where X is S and/or Se ;

of the perylene ;

of the diheterodipyrans of the general formula

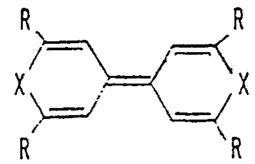

where X is S and/or Se or N-alkyl and R = alkyl or phenyl ;

of the tetramethylphenylenediamine ;

of the phthylocyanines and porphyrines ;

where the stoichiometric ratio of the charge transfer salt is less than 1, as an electron-beam sensitive resist material.

2. Use of chlorines, bromines, and iodines of tetrathiafulvalene, tetraselenafulvalene and diselenadithiafulvalene in accordance with claim 1.

3. Use of chlorines, bromines, and iodines of dimethyltetrathiafulvalene, tetramethyltretraselenafulvalene, and tetramethyldiselenadithiafulvalene in accordance with claim 1.

4. Use of chlorines, bromines, and iodines of tetramethyltetrathiafulvalene, tetramethyltetraselenafulvalene, and tetramethyldiselenadithiafulvalene in accordance with claim 1.

5. Method of chlorines, bromines, and iodines of hexamethylenetetrathiafulvalene, hexamethylenetetraselenafulvalene, and hexamethylenediselenadithiafulvalene in accordance with claim 1.

6. Use of chlorines, bromines, and iodines of tetrathiatetracene according to claim 1.

7. Use of chlorines, bromines, and iodines of tetrathianaphtalene and tetraselenanaphtalene in accordance with claim 1.

8. Use of chlorines, bromines, and iodines of dipyran, dithiopyran, and diselenapyran in accordance with claim 1.

9. Use of chlorines, bromines, and iodines of tetramethyldithiapyran, tetraphenyldithiapyran, tetramethyldiselenadipyran, and tetraphenyldiselenadipyran in accordance with claim 1.

10. Use of chlorines, bromines, and iodines of phthalocyanine, nickel phthalocyanine, copper phthalocyanine, cobalt phthalocyanine, iron phthalocyanine in accordance with claim 1.

11. Use of chlorines, bromines, and iodines of octamethyltetrabenzporphyrin in accordance with claim 1.

12. Method of making a positive resist image, where a film consisting of a conductive organic charge transfer material is deposited on a substrate, and irradiated with an electron-beam in a predetermined pattern, said beam being of a sufficient energy and current density to evaporate the film in the irradiated regions, forming a positive image, characterized in that a resist material in accordance with any one of claims 1 to 11 is used.

13. Method as claimed in claim 12, characterized in that an electron-beam with an energy of $8.01 \cdot 10^{-19}$ to $48.06 \cdot 10^{-19}$ J and a charge density of more than $10^{-3}$ to $10^{-1}$ C/cm$^2$ is used.

14. Method of making a negative resist image, where a film of a conductive organic charge transfer material is deposited on a substrate and irradiated with an electron-beam in a predetermined pattern, with sufficient energy and current density for cross-linking the film in the irradiated regions, and for removing the unexposed regions of the film with a solvent, forming a negative image, characterized in that a resist material in accordance with any one of claims 1 to 11 is used.

15. Method as claimed in claim 14, characterized in that an electron-beam with an energy of

8 . 01 . $10^{-19}$ to 48 . 06 . $10^{-19}$ J and a charge density of less than $10^{-3}$ to $10^{-4}$ $C/cm^2$ is used.

**Revendications**

1. Utilisation d'un matériau de transfert de charges organique conducteur du groupe des chlorures, bromures et iodures des tétrahétérofulvalènes de formule générale :

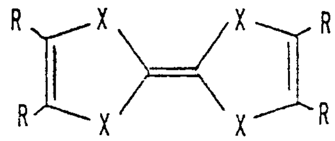

dans laquelle X représente S et/ou Se et R = H, alkyle, ou bien deux restes R voisins forment un groupe hexaméthylène ;
des tétrahétérotétracènes de formule générale :

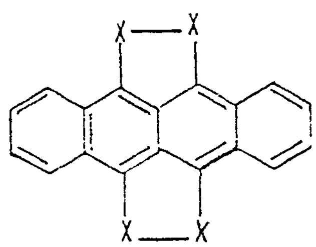

dans laquelle X représente S et/ou Se ;
des tétrahétéronaphtalènes de formule générale :

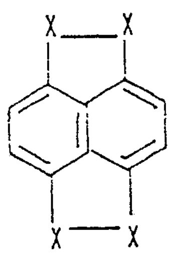

dans laquelle X représente S et/ou Se ;
du pérylène ;
des dihétérodipyrannes de formule générale :

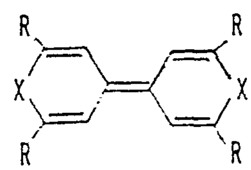

dans laquelle X représente S et/ou Se ou N-alkyle et R = alkyle ou phényle ;
de la tétraméthylphénylène-diamine ;
des phtalocyanines et des porphyrines ;
dans lesquels le rapport stœchiométrique du sel de transfert de charges est inférieur à 1, en tant que matière de résist sensible aux radiations électroniques.

2. Utilisation de chlorures, bromures et iodures du tétrathiofulvalène, du tétrasélénofulvalène et du disélénodithiofulvalène selon la revendication 1.

3. Utilisation de chlorures, bromures et iodures du diméthylétrathiofulvalène, du diméthyltétrasélénofulvalène et du diméthyldisélénodithiofulvalène selon la revendication 1.

4. Utilisation de chlorures, bromures et iodures du tétraméthyltétrathiofulvalène, du tétraméthyltétrasélénofulvalène, et du tétraméthyldisélénodithiofulvalène selon la revendication 1.

5. Utilisation de chlorures, bromures et iodures de l'hexaméthylène-tétrathiofulvalène, de l'hexaméthylènetétrasélénofulvalène, ou de l'hexaméthylène-disélénodithiofulvalène selon la revendication 1.

6. Utilisation de chlorures, bromures et iodures du tétrathiotétracène selon la revendication 1.

7. Utilisation de chlorures, bromures et iodures du tétrathionaphtalène et du tétrasélénaphtalène selon la revendication 1.

8. Utilisation de chlorures, bromures et iodures du dipyranne, du dithiodipyranne, et du disélénodipyranne selon la revendication 1.

9. Utilisation de chlorures, bromures et iodures du tétraméthyldithiodipyranne, du tétraphényldithiodipyranne, du tétraméthyldisélénodipyranne et du tétraphényldisélénodipyranne selon la revendication 1.

10. Utilisation de chlorures, bromures et iodures de phtalocyanine, de phtalocyanine de nickel, de cuivre, de cobalt et de fer, selon la revendication 1.

11. Utilisation de chlorures, bromures et iodures de l'octaméthyltétrabenzoporphyrine selon la revendication 1.

12. Procédé de préparation d'une image de résist positive dans lequel on applique une pellicule d'un matériau de transfert de charges organique conducteur sur un support et on irradie selon un modèle déterminé par des radiations électroniques ayant une énergie et une densité de courant suffisantes pour vaporiser la pellicule dans les régions irradiées avec formation d'une image positive, caractérisé en ce que l'on utilise une matière de résist selon l'une des revendications 1 à 11.

13. Procédé selon la revendication 12, caractérisé en ce que l'on utilise des radiations électroniques à une énergie de $8{,}01 \times 10^{-19}$ à $48{,}06 \times 10^{-19}$ J et une densité de charge allant de plus de $10^{-3}$ à $10^{-1}$ $C/cm^2$.

14. Procédé pour former une image de résist négative dans lequel on applique une pellicule sur un matériau de transfert de charges organique conducteur et on irradie selon un modèle déterminé par des radiations électroniques ayant une énergie et une densité de courant suffisantes pour réticuler la pellicule dans les régions irradiées et on élimine les régions non exposées de la pellicule à l'aide d'un solvant en formant une image négative, caractérisé en ce que l'on utilise une matière de résist selon l'une des revendications 1 à 11.

15. Procédé selon la revendication 14, caractérisé en ce que l'on utilise des radiations électroniques à une énergie de $8{,}01 \times 10^{-19}$ à $48{,}06 \times 10^{-19}$ J et une densité de charge inférieure à $10^{-3}$ et allant jusqu'à $10^{-4}$ $C/cm^2$.